# EUROPÄISCHE PATENTANMELDUNG

(11) **EP 3 284 555 A1**
(43) Veröffentlichungstag der Anmeldung: **21.02.2018**
(21) Anmeldenummer: 16184256.2
(22) Anmeldetag: 16.08.2016
(51) Int. Cl.: B23K 1/00, B23K 1/20, H05K 3/34, B23K 101/36, B23K 101/40

(54) **VERFAHREN ZUR HERSTELLUNG EINES NICHT GEWÖLBTEN LOTDEPOTS GERINGER RAUIGKEIT AUF EINER METALLOBERFLÄCHE**

(71) Anmelder: Heraeus Deutschland GmbH & Co. KG, 63450 Hanau (DE)
(72) Erfinder: Richter, Hans-Jürgen, 63450 Hanau (DE); Pelshaw, Nadja, 63517 Rodenbach (DE); Löwer, Yvonne, 63526 Erlensee (DE)
(74) Vertreter: Heraeus IP

(57) **Zusammenfassung**

Verfahren zur Herstellung eines Lotdepots auf einer Metalloberfläche, umfassend die Schritte:
a) Bereitstellen einer Metalloberfläche und eines Lotmaterials,
b) Aufbringen des Lotmaterials auf die Metalloberfläche,
c) Anordnen eines Templats auf dem aufgebrachten Lotmaterial aus Schritt b), wobei die Templatoberfläche durchgehend und nicht lötbar ist und die dem Lotmaterial zugewandte Templatoberfläche eine mittlere Oberflächenrauigkeit Ra (bestimmt nach DIN EN ISO 25178-6:2010-06) von nicht mehr als 40 µm aufweist,
d) Schmelzen des Lotmaterials während das Templat auf dem Lotmaterial platziert ist,
e) Abkühlen des geschmolzenen Lotmaterials unter seine Erstarrungstemperatur, und
f) Entfernen des Templats vom in Schritt e) gebildeten Lotdepot.

## Beschreibung

Die Erfindung betrifft ein Verfahren zur Herstellung eines nicht gewölbten Lotdepots geringer Rauigkeit auf einer Metalloberfläche, sowie das Lotdepot und die mit dem Verfahren erhältlichen Schichtaufbauten.

Der Einfachheit halber wird im Rahmen der vorliegenden Anmeldung durchgängig der Singular "ein Lotdepot" verwendet. Dies schließt allerdings nicht aus, dass mit dem erfindungsgemäßen Verfahren auch mehrere Lotdepots auf einer Metalloberfläche hergestellt werden können.

Löten zählt in der Elektronik zu einer gängigen Verbindungstechnik. Zum Beispiel werden damit standardmäßig Halbleiterchips auf Metalloberflächen befestigt, um Baugruppen für die Leistungselektronik herzustellen.

Die Metalloberflächen sind in der Leistungselektronik häufig Teil eines metallisierten Keramiksubstrats. Wenn es sich bei dem Metall um Kupfer handelt, spricht man auch von DCB-Substraten (Direct Copper Bonded).

Zur Herstellung einer Verbindung zwischen Metalloberfläche und Elektronikbauteil wird im ersten Schritt üblicherweise Lotmaterial auf die Metalloberfläche aufgetragen.

Dieses Lotmaterial kann beispielsweise in Form einer Lotvorform (solder preform) oder einer Lotpaste auf die Metalloberfläche aufgebracht werden und anschließend bis zum Schmelzen erhitzt werden. Durch das Schmelzen kann das Lot bereits eine Verbindung mit der Metalloberfläche eingehen. Dadurch wird auf der Metalloberfläche ein Lotdepot erzeugt. Anschließend kann in einem getrennten Schritt ein Elektronikbauteil (z.B. ein Halbleiterchip) auf dem Lotdepot aufgebracht und durch erneutes Schmelzen mit der Metalloberfläche verlötet werden.

Das beschriebene Verfahren hat einen Nachteil. Das beim ersten Aufschmelzen verflüssigte Lotmaterial bildet auf Grund der Oberflächenspannung eine gewölbte Oberfläche auf der von der Metalloberfläche abgewandten Seite aus. Nach dem Abkühlen des Lotdepots bleibt diese Wölbung erhalten. Die gewölbte Oberfläche des Lotdepots führt dazu, dass Elektronikbauteile, die auf dem Lotdepot im Folgenden angeordnet werden sollen, nicht zuverlässig positioniert werden können. Um z.B. Halbleiterchips besser auf den Lotdepots anordnen zu können, sind ebene, nicht gewölbte Lotdepots erforderlich.

DE102013225814 lehrt Verfahren zur Herstellung von Lotdepots auf Metalloberflächen ohne durch das Aufschmelzen bedingte Oberflächenwölbung. Dazu wird während des ersten Aufschmelzens des Lotmaterials ein Metallgewebe, beispielsweise ein Edelstahlnetz wie es für den Siebdruck verwendet wird, auf die Lotvorform gedrückt. Allerdings hinterlässt das Netz im Lotdepot einen Abdruck, der zu einer rauen Oberfläche führt. Raue Lotdepots sind für das Befestigen von Elektronikbauteilen aus mehreren Gründen nicht erwünscht. Da jede Wölbung des Netzabdrucks unterschiedlich hoch sein kann, können die Elektronikbauteile beim Aufsetzen auf dem Lotdepot verkippen oder verrutschen. Ein sicheres Positionieren von Elektronikbauteilen ist also nur sehr schwer möglich. Des Weiteren kann es beim Aufbringen elektronischer Bauteile, z.B. Halbleiterchips, auf das raue Lotdepot mit dem Netzabdruck und dem anschließenden Verlöten zu Gaseinschlüssen kommen. Solche Gaseinschlüsse, auch Lunker genannt, können unter anderem die Festigkeit von Lötstellen reduzieren und führen zu einer eingeschränkten Wärmeabfuhr von Bauteilen im Betrieb.

Aufgabe der vorliegenden Erfindung war es, ein einfaches Verfahren bereitzustellen, mit dem nicht gewölbte Lotdepots geringer Rauigkeit auf Metalloberflächen in einem Prozessschritt hergestellt werden können. Die mit dem zu findenden Verfahren hergestellten Lotdepots sollen es erlauben, Elektronikbauteile sicher zu platzieren, und die Bildung von Lunkern vermeiden.

Die Aufgabe wird gelöst durch ein Verfahren zur Herstellung eines Lotdepots auf einer Metalloberfläche, umfassend die Schritte:
a) Bereitstellen einer Metalloberfläche und eines Lotmaterials,
b) Aufbringen des Lotmaterials auf die Metalloberfläche,
c) Anordnen eines Templats auf dem aufgebrachten Lotmaterial aus Schritt b), wobei die Templatoberfläche durchgehend und nicht lötbar ist und die dem Lotmaterial zugewandte Templatoberfläche eine mittlere Oberflächenrauigkeit Rₐ (bestimmt nach DIN EN ISO 25178-6:2010-06) von nicht mehr als 40 µm aufweist,
d) Schmelzen des Lotmaterials während das Templat auf dem Lotmaterial platziert ist,
e) Abkühlen des geschmolzenen Lotmaterials unter seine Erstarrungstemperatur, und
f) Entfernen des Templats vom in Schritt e) gebildeten Lotdepot.

Hierin wird der Begriff "mittlere Oberflächenrauigkeit Rₐ" verwendet. Die mittlere Oberflächenrauigkeit Rₐ kann bestimmt werden nach DIN EN ISO 25178-6:2010-06.

Durch das erfindungsgemäße Verfahren können auf Metalloberflächen nicht gewölbte Lotdepots geringer Rauigkeit hergestellt werden, auf denen Elektronikbauteile wie z.B.

Halbleiterchips sicher und ohne Verrutschen und Verkippen positioniert werden können. Des Weiteren ist es möglich, dass die nicht gewölbten Lotdepots geringer Rauigkeit zu einer Verringerung von Lufteinschlüssen in der Lotverbindung von Elektronikbauteilen führen.

Weiterhin wurde überraschend festgestellt, dass die Verwendung durchgehender Template bzw. Template mit durchgehender Oberfläche, d.h. Template ohne Unterbrechungen, wie Löcher, Öffnungen oder Gewebemaschen, im erfindungsgemäßen Verfahren zu einer Verbesserung der Oberflächeneigenschaften des resultierenden Lotdepots führt.

In einem ersten Schritt (a) werden eine Metalloberfläche und ein Lotmaterial bereitgestellt.

Die Metalloberfläche kann eine erste Oberfläche einer eine erste und eine zweite Oberfläche aufweisenden Metallschicht sein, wobei die Metallschicht ausgewählt sein kann aus einem Metallblech, einem Metallbandabschnitt, einem Leadframe, einer eingebrannten Metall-Dickfilmpaste oder einem Metallfilm auf einem keramischem Substrat. Metallfilme auf keramischen Substraten umfassen auch sogenannte *Direct Copper Bonded* (DCB)-Substrate, wie sie in der Leistungselektronik zum Einsatz kommen. Im Rahmen der vorliegenden Erfindung handelt es sich bei der Metallschicht bevorzugt um einen Metallfilm, der Teil eines DCB-Substrats ist. Wenn die Metallschicht Teil eines DCB-Substrats ist, kann die erste Metalloberfläche ein Lotmaterial kontaktieren und die zweite Oberfläche der Metallschicht kann auf einem Keramikträger, z.B. aus Aluminiumoxid, Aluminiumnitrid oder Siliziumnitrid angeordnet sein. Dies ist schematisch in folgender Abb. 1 dargestellt:

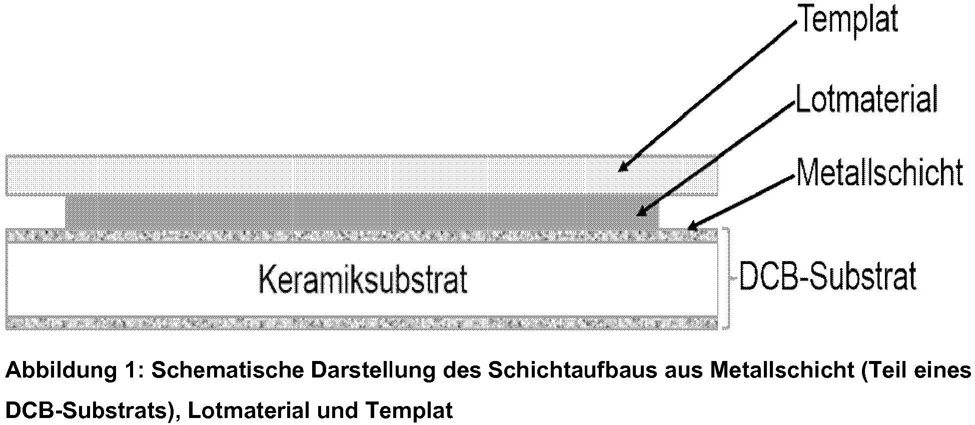

Die Metallschicht kann ein Material aufweisen, dass aus der Gruppe bestehend aus Au, Ag, Pd, Pt, Cu, Ni und Sn ausgewählt ist. Die Metallschicht kann aus einem reinen Metall bestehen oder eine Legierung der Elemente ausgewählt aus der Gruppe bestehend aus Au, Ag, Pd, Pt, Cu, Ni und Sn aufweisen. Bevorzugt ist die Metallschicht aus Kupfer.

Die Metalloberfläche der Metallschicht kann aus einem reinen Metall oder einer Legierung bestehen. Das reine Metall kann ausgewählt sein aus der Gruppe bestehend aus Au, Ag, Pd, Pt, Cu, Ni und Sn. Bevorzugt ist das reine Metall Kupfer. In einer Ausführungsform der Erfindung ist das Material der Metallschicht und der Metalloberfläche gleich. In einer alternativen Ausführungsform ist es möglich, dass die Metallschicht eine Metalloberfläche aus einem anderen Metall oder einer anderen Legierung aufweist (auch Metallisierung genannt). Die Metallschicht kann also in einer Ausführungsform eine Schicht eines reinen Metalls, z.B. Kupfer, aufweisen, wobei die Metallschicht eine Metallisierung aus einem anderen Metall ausgewählt aus der Gruppe bestehend aus Au, Ag, Pd, Pt, Cu, Ni und Sn aufweisen kann. Unter einer Metallisierung ist im Rahmen der Erfindung ein dünner Film zu verstehen, dessen Dicke gewöhnlich um etwa eine Größenordnung geringer ist als die Dicke der Metallschicht. Die Metallisierung kann auch eine Legierung der Metalle ausgewählt aus der Gruppe bestehend aus Au, Ag, Pd, Pt, Cu, Ni und Sn sein. Insbesondere handelt es sich bei der Metallisierung der Metallschicht um ein NiAg oder NiAu Legierung. Durch die Metallisierung der Metallschicht kann das Material der Metallschicht von dem Oberflächenmaterial abweichen. Als besonders bevorzugte Ausführungsform ist eine Kupferschicht zu nennen, die mit einer Metallisierung aus NiAg oder NiAu versehen ist.

Das bereitgestellte Lotmaterial umfasst mindestens eine Lotlegierung aufweisend eine Schmelztemperatur von 50°C bis 1000°C, insbesondere 170°C bis 350°C. Das Lotmaterial umfasst mindestens eine Lotlegierung von Elementen, die ausgewählt sind aus der Gruppe bestehend aus Sn, In, Cu, Ag, Bi, Sb, Cd, Au, Ge, Ni und Pb. Die Legierungen können sowohl bleihaltig als auch bleifrei sein. Bleifreie Legierungen können beispielsweise ausgewählt sein aus der Gruppe bestehend aus SnAg, SnBi, SnSb, SnAgCu, SnCu, SnSb, InSnCd, InBiSn, InSn, BiSnAg oder SnAgCuBiSbNi. Bleihaltige Legierungen können beispielsweise ausgewählt sein aus der Gruppe umfassend SnPb und SnPbAg.

Im darauffolgenden Schritt b) wird das Lotmaterial auf die Metalloberfläche aufgebracht. Es gibt grundsätzlich verschiedene Möglichkeiten, wie das Lotmaterial auf die Metalloberfläche aufgebracht werden kann.

In einer ersten Ausführungsform kann das Lotmaterial in Form einer Lotvorform auf die Metalloberfläche aufgebracht werden. Unter einer Lotvorform versteht der Fachmann ein Metallformteil aus einer Lotlegierung, wie beispielsweise eine Folie oder ein Band. Die Dicke der Lotvorform kann im Bereich von 25 µm bis 1,5 cm liegen. Typischer Weise ist die Lotvorform eine Folie mit einer Dicke im Bereich von 50 µm bis 300 µm. Optional kann die Lotvorform auf ihrer Oberfläche ein Flussmittel aufweisen. Unter Flussmittel werden üblicher Weise solche Stoffe verstanden, die bewirken, dass die zu lötenden Oberflächen reduziert werden und keine Oxide mehr aufweisen.

In einer weiteren Ausführungsform kann das Lotmaterial in Form einer Lotpaste auf die Metalloberfläche aufgebracht werden. Eine Lotpaste umfasst typischer Weise mindestens ein Pulver einer Lotlegierung und ein organisches Vehikel sowie optional ein Flussmittel. Das organische Vehikel kann Lösungsmittel sowie Hilfsstoffe zum Einstellen der Eigenschaften der Paste enthalten. Die Hilfsstoffe können beispielsweise ausgewählt sein aus der Gruppe bestehend aus Polymeren, Harzen, Tensiden und Thixotropiemitteln. Beim Erhitzen einer Lotpaste verflüchtigen sich die organischen Bestandteile der Lotpaste weitestgehend, sodass nach dem Erkalten die Lotlegierung übrig bleibt. Die Lotpaste kann auf verschiedene Arten auf die Metalloberfläche aufgebracht werden, beispielsweise mittels Druckverfahren, wie z.B. Siebdruck, Schablonendruck oder Spritzen (Dispensing). Die Dicke der aufgebrachten Lotpaste kann im Bereich von 50 µm bis 300 µm liegen. Nachdem die Lotpaste auf die Metalloberfläche aufgebracht wurde, kann die Lotpaste getrocknet werden oder alternativ kann die Lotpaste ohne Trocknungsschritt direkt weiterverarbeitet werden. Bevorzugt wird die aus einer Lotpaste hergestellte Schicht ohne Trocknungsschritt weiterverarbeitet.

Die Fläche und die Form des aufgebrachten Lotmaterials ist grundsätzlich nicht beschränkt, sie liegt jedoch bevorzugt im Bereich von 500 µm x 500 µm bis 50 mm x 50 mm insbesondere im Bereich von 5 mm x 5 mm bis 12 mm x 12 mm. Es versteht sich im Rahmen der Erfindung, dass die Grundfläche des aufgebrachten Lotmaterials nicht auf quadratische Formen beschränkt ist, sondern beliebige Formen annehmen kann.

In Schritt c) wird ein Templat auf dem Lotmaterial aus b) angeordnet. Dadurch wird der erfindungsgemäße Schichtaufbau realisiert. In dem erfindungsgemäßen Schichtaufbau ist das Lotmaterial aus b) nicht durch eine Lotverbindung mit der Metallschicht verbunden, wenn das Templat auf dem Lotmaterial angeordnet wird.

Es versteht sich für den Fachmann von selbst, dass die dem Lotmaterial zugewandte Oberfläche des Templats keine Wölbung aufweist, da eine solche Wölbung auf das herzustellende Lotdepot übertragen würde.

Das Templat weist eine durchgehende Oberfläche eines Materials auf, das nicht über eine Lotverbindung mit dem Lotmaterial verbunden werden kann, also nicht lötbar ist. Diese nicht lötbare Templatoberfläche ist dem Lotmaterial zugewandt und kontaktiert das Lotmaterial. Die nicht lötbare Templatoberfläche ist wie schon gesagt eine durchgehende Oberfläche, d.h. ohne Unterbrechungen wie beispielsweise Löcher, Öffnungen oder Maschen.

Das Templat weist auf der dem Lotmaterial zugewandten Oberfläche eine mittlere Oberflächenrauigkeit Rₐ von nicht mehr als 40 µm auf. Bevorzugter Weise beträgt die mittlere Oberflächenrauigkeit Rₐ der Templatoberfläche nicht mehr als 25 µm, insbesondere nicht mehr als 15 µm. Die nicht-lötbare Oberfläche des Templats kann ein Material aufweisen, das ausgewählt ist aus der Gruppe bestehend aus Glas, Keramik, und Metall. Die Keramik kann eine Oxidkeramik oder eine Nicht-Oxidkeramik (z.B. ein Metallnitrid oder ein Metallcarbid) sein, insbesondere eine Oxidkeramik aufweisend mindestens ein Element ausgewählt aus der Gruppe bestehend aus Aluminium, Titan und Zirkon. In einer besonders bevorzugten Ausführungsform handelt es sich bei den Oxidkeramiken um Aluminiumoxid und/oder Titandioxid. Das Metall kann beispielsweise Edelstahl sein.

In einer besonders bevorzugten Ausführungsform handelt es sich bei dem Templat um ein Keramikplättchen mit einer Dicke im Bereich von 0,5 - 3 mm.

Bei dem Anordnen sollte bevorzugt darauf geachtet werden, dass das Templat in alle Richtungen über das aufgebrachte Lotmaterial hinaussteht. In einer bevorzugten Ausführungsform ist die Fläche des Templats, die auf dem Lotmaterial angeordnet wird, mindestens 5%, insbesondere mindestens 10% größer als die Kontaktfläche von Lotmaterial und Metalloberfläche.

In Schritt d) wird das Lotmaterial geschmolzen während das Templat auf dem Lotmaterial platziert ist. Dazu wird der Schichtaufbau aus Metallschicht, aufgebrachtem Lotmaterial und Templat so erhitzt, dass das Lotmaterial schmilzt und eine Lötverbindung mit der Metalloberfläche der Metallschicht eingehen kann. Typischer Weise liegt die Schmelztemperatur des Lotmaterials im Bereich von 170°C - 350°C. Dadurch, dass sich das Templat während des Schmelzens des Lotmaterials auf letzterem befindet, wird eine Wölbung des flüssigen Lotmaterials vermieden. Das geschmolzene, flüssige Lotmaterial kann sich der ihm zugewandten Templatoberfläche anpassen.

Sowohl durch das Eigengewicht des Templats als auch durch mechanisches Fixieren des Templats kann der mechanische Druck, der auf das geschmolzene Lotmaterial einwirkt, eingestellt werden. Bevorzugt wird der Druck auf das geschmolzene Lotmaterial so eingestellt, dass eine Wölbung vermieden wird und sich gleichzeitig die Grundfläche des aufgebrachten Lotmaterials nicht wesentlich (z.B. nicht mehr als 20%) ändert. In einer Ausführungsform der Erfindung kann das Eigengewicht des Templats, z.B. eines Keramikplättchens, ausreichen, um der Wölbung des geschmolzenen Lotmaterials entgegen zu wirken. Alternativ kann das Templat während des Schmelzens auch zusätzlich mechanisch befestigt sein, z.B. mittels eines Stempels, der während des Schmelzens in der gewünschten Position gehalten wird.

Man kann das Templat auch erst auf das geschmolzene Lotmaterial aufbringen.

Das Erhitzen des Schichtaufbaus kann stufenweise oder kontinuierlich erfolgen. Beispielsweise können ein oder mehrere Temperaturplateaus erreicht werden, bei denen die Temperatur für eine definierte Zeit konstant gehalten wird. Dies kann insbesondere dazu dienen, die zu lötenden Oberflächen durch das Einwirken von Flussmittel zu aktivieren (von eventuell vorhandenen Oxiden zu befreien) und ist dem Fachmann grundsätzlich bekannt.

In einer Ausführungsform kann der Schmelzprozess bei Atmosphärendruck ablaufen. Insbesondere, wenn das Lotmaterial in Form einer Lotvorform bereitgestellt wurde, kann auf eine Prozessführung bei Unterdruck verzichtet werden, was das Verfahren stark vereinfacht.

Je nach verwendetem Lotmaterial kann es zusätzlich vorteilhaft sein, dass ein Vakuum während des Schmelzens angelegt wird.

In Schritt e) wird das geschmolzene Lotmaterials unter seine Erstarrungstemperatur abgekühlt. Mit anderen Worten, nach erfolgtem Schmelzen wird der Schichtaufbau abgekühlt. Sobald das vorher geschmolzene Lotmaterial wieder erstarrt ist, kann das Templat entfernt werden.

In Schritt f) wird das Templat vom in Schritt e) gebildeten Lotdepot entfernt und dadurch das fertige Lotdepot erzeugt. Das Entfernen des Templats geschieht vorzugsweise derart, dass die Topografie des Lotdepots dabei nicht verändert wird. Das Lotmaterial und das Templatmaterial sind so abgestimmt, dass nach einem Zyklus aus Schmelzen und Abkühlen das Templat ohne Veränderung der Topografie entfernt werden kann.

Das erkaltete Lotmaterial gibt bevorzugt maximal 50 % der mittleren Oberflächenrauigkeit Rₐ des Templats wieder und stellt das fertige Lotdepot dar. Überraschender Weise wurde gefunden, dass sich selbst mit Templatoberflächen, die eine höhere mittlere Oberflächenrauigkeit Rₐ aufweisen, eine deutlich niedrigere, mittlere Oberflächenrauigkeit Rₐ des fertigen Lotdepots erzielen lässt. Zum Beispiel kann durch Verwendung eines Templats mit einem Rₐ-Wert von etwa 15 µm ein Lotdepot mit einem Rₐ-Wert von weniger als 5 µm erzielt werden.

Durch das erfindungsgemäße Verfahren kann in einem Prozessschritt ein Lotdepot mit einer Metalloberfläche über eine Lötverbindung verbunden werden und gleichzeitig die Wölbung der Oberfläche des Lotdepots vermieden werden. Typischer Weise weist eine solche Lotverbindung zwischen Lotdepot und Metalloberfläche eine dünne Legierungsschicht der miteinander verbundenen Metalle auf.

Durch das erfindungsgemäße Verfahren kann ein Lotdepot mit einer ebenen Oberfläche mit einer mittleren Oberflächenrauigkeit Rₐ von weniger als 10 µm, insbesondere weniger als 7,5 µm und ganz besonders bevorzugt von weniger als 5 µm bereitgestellt werden. In den vorgenannten Fällen wird die mittlere Oberflächenrauigkeit Rₐ jeweils über eine Messstrecke von mindestens 250 µm bestimmt.

Auf Grund der ebenen, nicht gewölbten Oberfläche und der geringen mittleren Oberflächenrauigkeit Rₐ des erfindungsgemäßen Lotdepots können Halbleiterchips besser ohne Verkippen (engl.: *tilt*) oder Verrutschen auf dem Lotdepot positioniert werden.

### Beispiele

### Beispiel 1

Im Rahmen der vorliegenden Erfindung wurde die mittlere Oberflächenrauigkeit Rₐ sämtlicher Proben gemäß DIN EN ISO 25178-6:2010-06 mit einem Lasermesssystem basierend auf dem Messprinzip des konfokalen Mikroskops der Marke µsprint topographer (Nano Focus AG, Deutschland) gemessen.

### Beispiel 2

Mit einer Lotpaste enthaltend SnAg3.5 (F823, Heraeus Deutschland GmbH, Deutschland) wurde mittels Schablonendruck eine Schicht auf einer Fläche von 9 mm x 9 mm auf die Metalloberfläche eines DCB-Substrats aufgetragen. Die Dicke der feuchten gedruckten Schicht betrug etwa 180 µm. Auf der gedruckten Schicht wurde als Templat ein Plättchen aus Aluminiumoxid mit einer Fläche von 25 mm x 25 mm und einer Dicke von 1 mm angeordnet (mittlere Oberflächenrauigkeit Rₐ 14,4 µm). Der hergestellte Schichtaufbau aus DCB-Substrat, Lotpaste und Templat wurde in einer Lötanlage (Pink Vadu 200 XL) unter Verwendung des folgenden Lotprofils erhitzt:
- Aufheizen auf 80°C Substrattemperatur mit einer Aufheizrate von 2,33 K/s und Halten der Temperatur für 30 s
- Aufheizen auf 150°C Substrattemperatur mit einer Aufheizrate von 2,33 K/s und Halten der Temperatur für 30 s
- Aufheizen auf 250°C Substrattemperatur mit einer Aufheizrate von 2,33 K/s und Halten für 10 s
- Evakuieren auf 300 mbar bei 250°C - Halten für 5 s
- Evakuieren auf 20 mbar bei 250°C - Halten für 40 s
- Fluten der Lötkammer mit Stickstoff bis zu einem Druck von 950 mbar

Anschließend wurden Flussmittelrückstande mittels Waschanlage pbt SuperSwash unter Verwendung des Reinigers Zestron PE200 entfernt.

Es resultierte ein nicht gewölbtes Lotdepot mit einer Dicke von ungefähr 175 µm und einer mittleren Oberflächenrauigkeit Rₐ des erzeugten Lotdepots von 4,4 µm, wie in folgender Abb. 2 dargestellt:

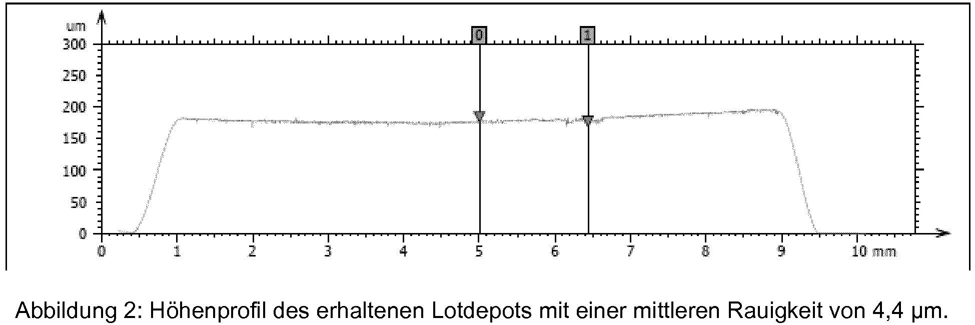

## Patentansprüche

1. Verfahren zur Herstellung eines Lotdepots auf einer Metalloberfläche, umfassend die Schritte:
a) Bereitstellen einer Metalloberfläche und eines Lotmaterials,
b) Aufbringen des Lotmaterials auf die Metalloberfläche,
c) Anordnen eines Templats auf dem aufgebrachten Lotmaterial aus Schritt b), wobei die Templatoberfläche durchgehend und nicht lötbar ist und die dem Lotmaterial zugewandte Templatoberfläche eine mittlere Oberflächenrauigkeit Rₐ (bestimmt nach DIN EN ISO 25178-6:2010-06 ) von nicht mehr als 40 µm aufweist,
d) Schmelzen des Lotmaterials während das Templat auf dem Lotmaterial platziert ist,
e) Abkühlen des geschmolzenen Lotmaterials unter seine Erstarrungstemperatur, und
f) Entfernen des Templats vom in Schritt e) gebildeten Lotdepot.

2. Verfahren gemäß Anspruch 1, wobei das Lotmaterial in Form einer Lotvorform oder einer Lotpaste bereitgestellt wird.

3. Verfahren gemäß einem der Ansprüche 1 oder 2, **dadurch gekennzeichnet, dass** die Templatoberfläche, die mit dem Lotmaterial in Kontakt steht, ein Material aufweist oder ist, das ausgewählt ist aus der Gruppe bestehend aus Glas, Keramik und Metall.

4. Verfahren gemäß einem der Ansprüche 1-3, **dadurch gekennzeichnet, dass** das keramische Material eine Oxidkeramik ist.

5. Verfahren gemäß einem der Ansprüche 1-4, **dadurch gekennzeichnet, dass** die Oxidkeramik mindestens ein Element ausgewählt aus der Gruppe bestehend aus Aluminium, Titan und Zirkon aufweist.

6. Verfahren gemäß einem der Ansprüche 1-5, **dadurch gekennzeichnet, dass** die Metalloberfläche Kupfer aufweist.

7. Verfahren gemäß Anspruch 6, **dadurch gekennzeichnet, dass** die Metalloberfläche Teil eines DCB-Substrats ist.

8. Schichtaufbau zur Herstellung eines Lotdepots auf einer Metalloberfläche, aufweisend:
a. mindestens eine Metallschicht mit einer ersten und einer zweiten Metalloberfläche
b. mindestens eine Schicht eines Lotmaterials auf der ersten Metalloberfläche, und
c. ein durchgehendes nicht lötbares Templat auf dem Lotmaterial,
wobei die dem Lotmaterial zugewandte Templatoberfläche eine mittlere Oberflächenrauigkeit Rₐ (bestimmt nach DIN EN ISO 25178-6:2010-06) von nicht mehr als 40 µm aufweist, **dadurch gekennzeichnet, dass** die Schicht des Lotmaterials keine Lotverbindung mit der ersten Oberfläche der Metallschicht aufweist.

9. Lotdepot auf einer Metalloberfläche, wobei das Lotdepot durch einen Lötkontakt mit der Oberfläche verbunden ist, **dadurch gekennzeichnet, dass** das Lotdepot eine mittlere Oberflächenrauigkeit Rₐ (bestimmt nach DIN EN ISO 25178-6:2010-06) von < 10 µm aufweist.

10. Verwendung des Lotdepots gemäß Anspruch 9 für Lötanwendungen in der Elektronik.
